(19) Europäisches Patentamt / European Patent Office / Office européen des brevets

(11) EP 2 213 692 A1

(12) **EUROPEAN PATENT APPLICATION**

(43) Date of publication:
**04.08.2010 Bulletin 2010/31**

(21) Application number: **09150157.7**

(22) Date of filing: **07.01.2009**

(51) Int Cl.:
***C08G 61/02*** *(2006.01)* ***C08G 61/12*** *(2006.01)*
***H01L 51/00*** *(2006.01)* ***H01L 51/05*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **14.01.2008 US 13700**

(71) Applicant: **Xerox Corporation**
**Rochester,**
**New York 14644 (US)**

(72) Inventors:
- **Pan, Hualong**
  **Ottawa Ontario K1J 7N4 (CA)**
- **Wu, Yiliang**
  **Mississauga Ontario L5M 7K3 (CA)**
- **Liu, Ping**
  **Mississauga Ontario L5M 3H2 (CA)**
- **Li, Yuning**
  **128044, Singapore (SG)**
- **Smith, Paul F.**
  **Oakville Ontario L6J 2G2 (CA)**
- **Mahabadi, Hadi K.**
  **Mississauga Ontario L5K 2L1 (CA)**

(74) Representative: **Grünecker, Kinkeldey,**
**Stockmair & Schwanhäusser**
**Anwaltssozietät**
**Leopoldstrasse 4**
**80802 München (DE)**

(54) **Polymer Semiconductors with High Mobility**

(57) A polymer semiconductor compound of the below formula,

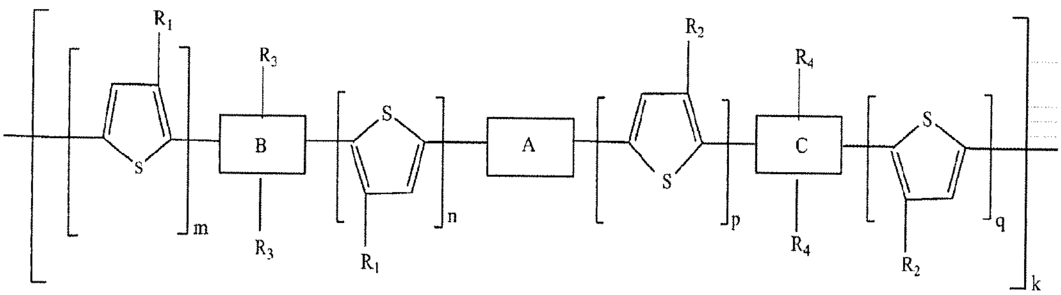

wherein the side chains, $R_1$, $R_2$, $R_3$ and $R_4$, are arranged in a manner that promotes high mobility and to provide a weak side chain interaction.

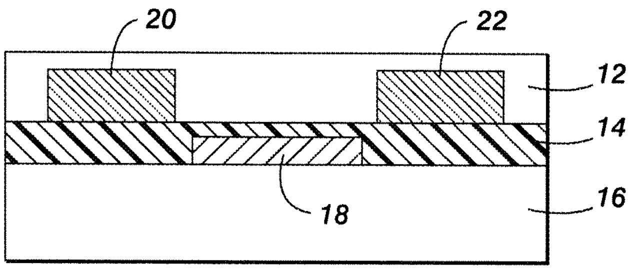


*FIG. 1*

EP 2 213 692 A1

## Description

### BACKGROUND

Fabrication of printed organic electronics (POE) is of profound interest, as such devices are ultra-low cost, are solution processable, and possess mechanical durability and structural flexibility. One type of POE, a printed thin film transistors (TFT), has received much attention in recent years as it is a promising, low cost alternatives to silicon technology for application in, for example, active-matrix liquid crystal displays (LCDs), organic light emitting diodes, e-paper, radio frequency identification tags (RFIDs).

The above characteristics are desirable for fabricating flexible TFTs on a number of substrates, including plastic substrates. The use of a plastic substrate with a polymer semiconductor can transform a rigid silicon TFT into a mechanically more durable and structurally flexible TFT. This transformation can be of particular value to large area devices such as large-area image sensors, electronic paper and other display media.

Polymer semiconductors, such as poly[5,5'-bis(3-dodecyl-2-thienyl)-2,2'-bithiophene] (PQT), have a mobility of 0.1-0.2 $cm^2/V \cdot s$. However, if two substituted or unsubstituted thiophene rings in the repeating unit of PQT are fused together, the mobilities of the PQT derivatives such as poly(2,5-bis-(3-alkylthiophen-2-yl)-thieno[3,2-*b*]thiophene) and poly(2,5-bis(2-thienyl)-3,6-dialkylthieno[3,2-b]thiophene), increase by at least a factor of 2. This result illustrates that a larger fused ring induces better intermolecular pi conjugation and better intramolecular pi-pi stacking, thus better mobility. However, if the two thiophene rings are fused linearly or parallel to the polymer's backbone, low solubility often results.

Further, heating the substrate or "annealing" is an important step in manufacturing current POE devices based on the PQT and it's derivative polymers. This time and energy consuming annealing process is not compatible with a roll-to-roll massive manufacturing process utilized to fabricate a low cost POE.

The above and other issues are addressed by the present application, wherein in embodiments, the application relates to a class of polymer semiconductors with pi conjugation extended perpendicular to the backbone direction to yield a weak side chain interaction. A polymer semiconductor with the pi conjugation extended perpendicular to the backbone promotes solubility and crystallinity. Also, a polymer semiconductor with a weak side chain interaction allows for the preparation of high performance polymer semiconductors without the need for high temperature annealing.

### SUMMARY

The present application thus achieves advances over prior polymer semiconductors and discloses a polymer semiconductor where various side chains are arranged in a manner to provide no or weak side chain interactions, and thus achieves high field-effect mobility without thermal annealing. The present application also achieves advances over prior polymer semiconductors and discloses a polymer semiconductor wherein the fusing ring structure is extended perpendicular to the conjugated backbone, thus achieving both good solubility and high crystallinity for high mobility.

The present invention provides:

(1) A polymer semiconductor compound of Formula 1,

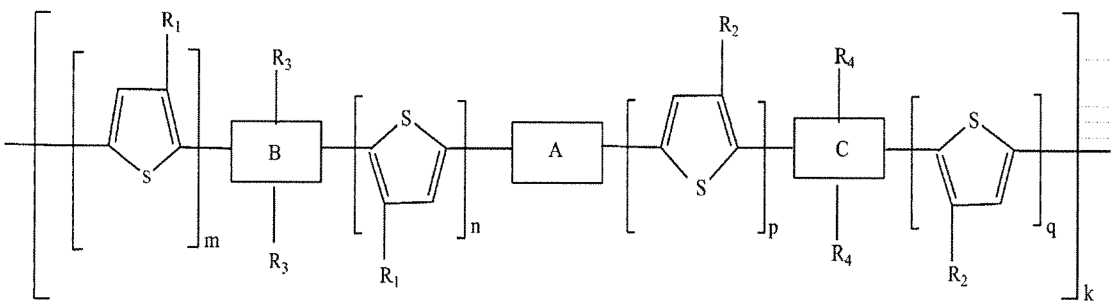

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,

wherein k represents the number of repeating units of from 1 to about 200; A is a divalent linkage; and B and C are independently selected from the group consisting of a bond, a divalent linkage, and combinations thereof,

wherein m, n, p and q each individually represent from 0 to about 20,
wherein if the both B and C are thieno[3,2-*b*]thiophene, m and n cannot be 1 and p and q cannot be 1, and wherein $R_1$, $R_2$, $R_3$ and $R_4$ are arranged in a manner promoting high mobility and providing a weak side chain interaction.

(2) A polymer semiconductor compound according to (1), wherein $R_1$, $R_2$, $R_3$ and $R_4$ extend perpendicular to the backbone of the polymer semiconductor.

(3) A polymer semiconductor compound according to (1), wherein substituting a fused aromatic to the backbone of the polymer semiconductor increases the crystallinity of the polymer semiconductor by a factor of at least about 1.5.

(4) A polymer semiconductor compound according to (3), wherein the fused aromatic has an extended pi-conjugation perpendicular to the backbone of the polymer semiconductor.

(5) A polymer semiconductor compound according to (3), wherein the fused aromatic is

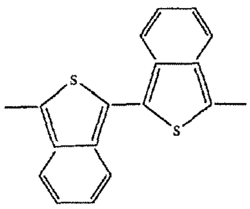 , 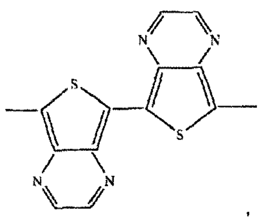 , 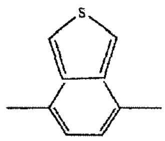 ,

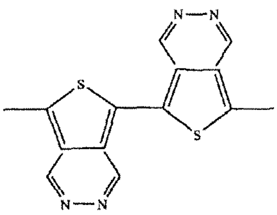 , 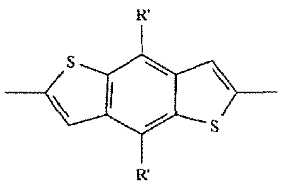 , 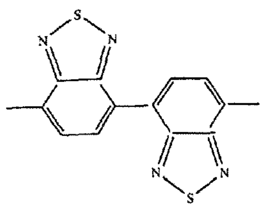 ,

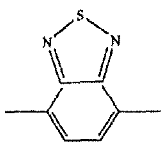 , 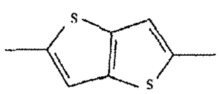 , 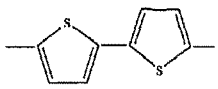

or mixtures thereof.

(6) A polymer semiconductor compound according to (1), wherein the polymer semiconductor does not include a simultaneous substitution at the third ring position of two adjacent thiophene units.

(7) A polymer semiconductor compound according to (1), wherein at least one $R_1$, $R_2$, $R_3$ and $R_4$ is a hydrocarbon group.

(8) A polymer semiconductor compound according to (7), wherein the hydrocarbon group is an unsubstituted hydrocarbon comprising from 1 to about 30 carbon atoms selected from a group consisting of a straight chain alkyl group, branched alkyl group, cycloalkyl group, aryl group, alkylaryl group, arylalkyl group and combinations thereof.

(9) A polymer semiconductor compound according to (7), wherein the hydrocarbon group is a substituted hydrocarbon comprising 1 to about 40 carbon atoms and selected from a group consisting of straight chain alkyl group, branched alkyl group, cycloalkyl group, aryl group, alkylaryl group, arylalkyl group and combinations thereof and substituted one or more times with chlorine, bromine, fluorine, iodine, sulfur, amino, nitro, cyano, methoxyl, ethoxyl, and propoxyl.

(10) A polymer semiconductor compound according to (1), wherein the divalent linkage of A is independently selected from a group consisting of:

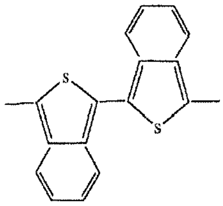 , 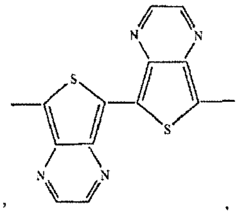 , 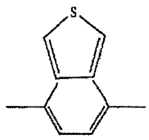 ,

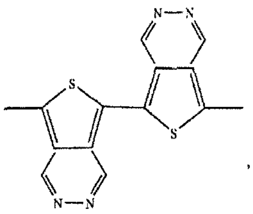 , 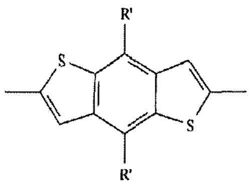 , 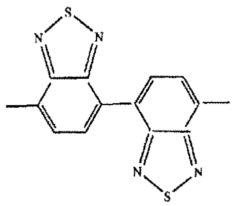 ,

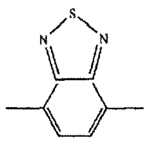 , 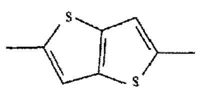 , 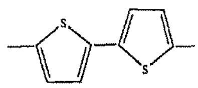

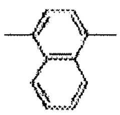 , 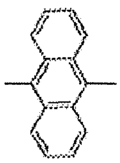 , 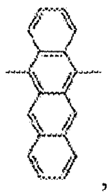 , 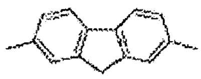 , 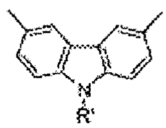 ,

and combinations thereof, and wherein the divalent linkage of B and C is independently selected from a group consisting of:

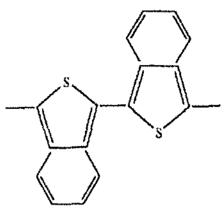 , 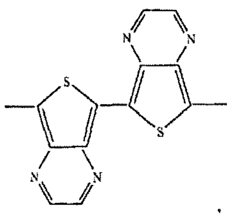 , 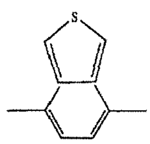 ,

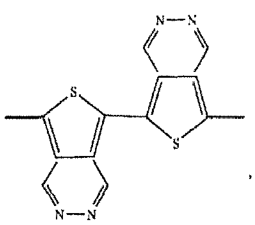 , 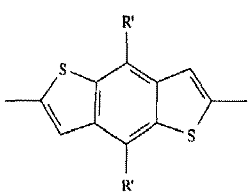 , 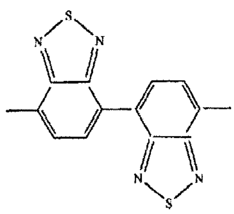 ,

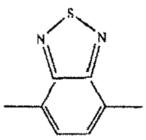, 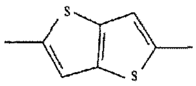, 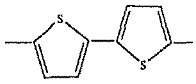

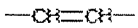, 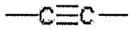, 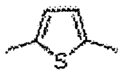, 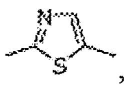, 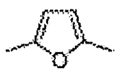, 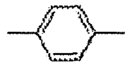, 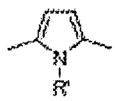,

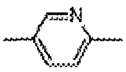, 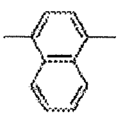, 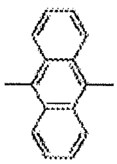, 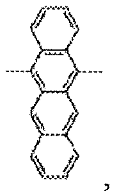, 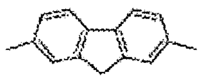, 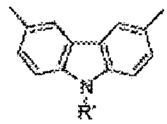

and

combinations thereof.

(11) A polymer semiconductor compound according to (1), wherein the chemical structure of the polymer semiconductor compound has a formula selected from a group consisting of:

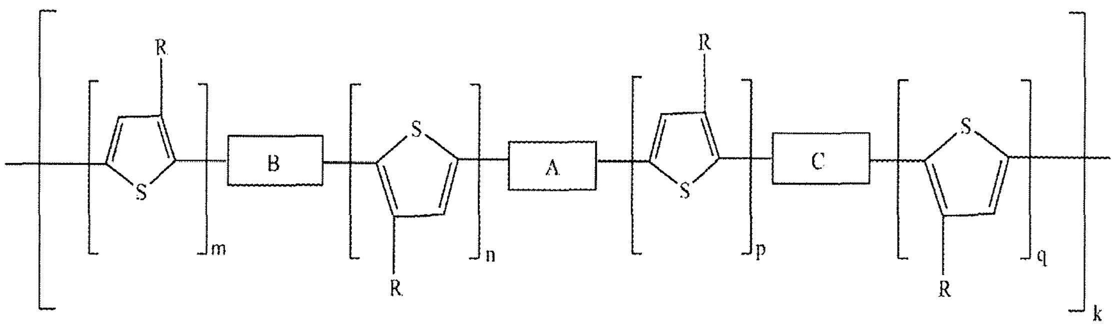

(2)

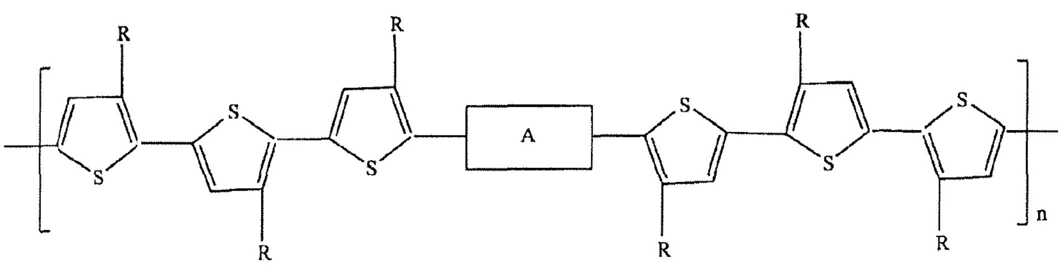

(3)

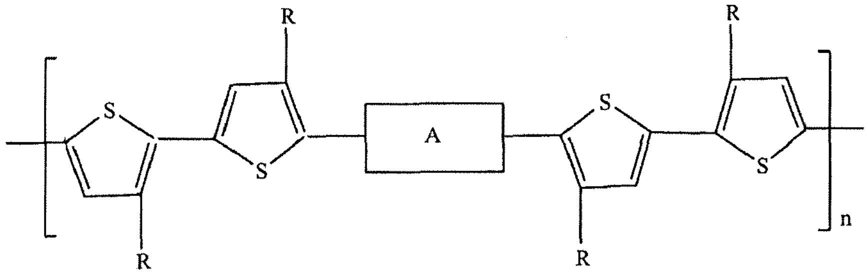

(4)

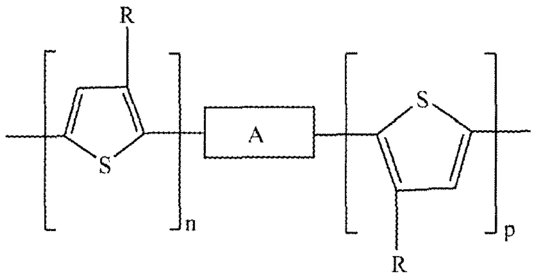

(5)

and

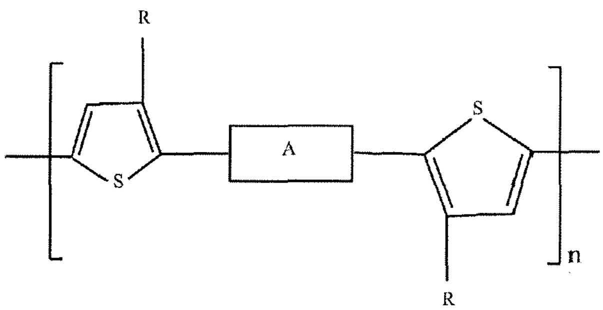

(6)

wherein R is a side chain arranged perpendicular to the backbone of the polymer semiconductor, to promote high mobility and to a provide weak side chain interaction.

(12) A polymer semiconductor compound according to (11), wherein R is a side chain independently selected from the group consisting of a hydrogen atom, a heteroatom, an unsubstituted hydrocarbon group comprising from 1 to about 30 carbon atoms, and a substituted hydrocarbon group comprising from 1 to about 40 carbon atoms substituted one or more times with chlorine, bromine, fluorine, iodine, cyano, nitro, methoxyl, ethoxyl and propoxyl.

(13) A polymer semiconductor compound according to (1), wherein the mobility of the polymer semiconductor compound is greater than 0.1 $cm^2/V \cdot s$.

(14) A polymer semiconductor compound according to (1), wherein the weak side chain interaction is achieved by narrowing or widening the repeating distance between side chains.

(15) A polymer semiconductor compound according to (1), wherein the polymer semiconductor has a symmetric repeating unit and has a weak side chain interaction due to no side chain interdigitation.

(16) A polymer semiconductor compound according to (1), wherein the polymer semiconductor has no side chain melting.

(17) A polymer semiconductor compound according to (1), wherein the weak side chain interaction is achieved by

substituting a bulky hydrocarbon group.

(18) A polymer semiconductor compound according to (17), wherein the bulky side chain is a hydrocarbon group containing at least 10 carbon atoms.

(19) A thin-film transistor comprised of a polymer semiconductor layer having a polymer semiconductor compound of Formula 1,

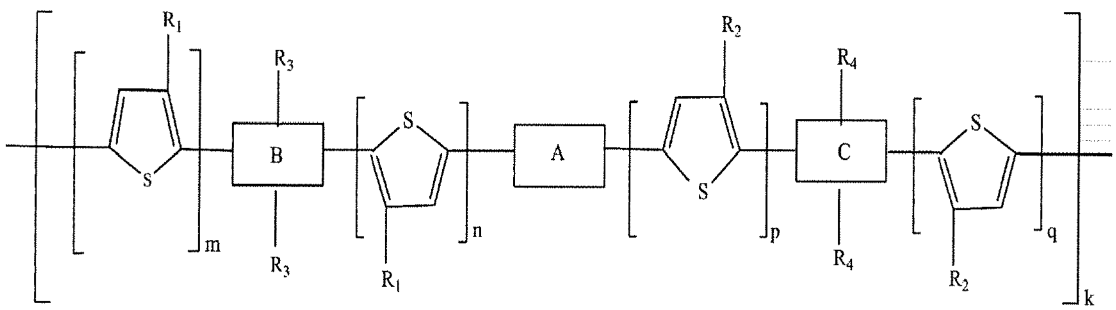

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,

wherein k represents the number of repeating units of from 1 to about 200; A is a divalent linkage; and B and C are independently selected from the group consisting of a bond, a divalent linkage, and combinations thereof,

wherein m, n, p and q each individually represent from 0 to about 20,

wherein if the both B and C are thieno[3,2-*b*]thiophene, m and n cannot be 1 and p and q cannot be 1, and wherein $R_1$, $R_2$, $R_3$ and $R_4$ are arranged in a manner promoting high mobility and providing a weak side chain interaction.

(20) A thin-film transistor according to (19), wherein the thin-film transistor is annealed at a temperature below about 150 °C.

(21) A thin-film transistor according to (19), wherein the thin-film transistor is annealed at a temperature below about 100 °C.

(22) A thin-film transistor according to (19), wherein the polymer semiconductor has a symmetric repeating unit and the polymer semiconductor has a weak side chain interaction due to no side chain interdigitation.

(23) A thin-film transistor according to (19), wherein thin-film transistor has a mobility greater than 0.1 $cm^2/V \cdot s$.

(24) A method of manufacturing a thin-film transistor, which comprises a substrate, a gate electrode, a gate dielectric layer, an insulating layer, a source electrode and a drain electrode and in contact with the source/drain electrodes and the gate dielectric layer, a semiconductor layer comprised of a polymer semiconductor compound of formula 1,

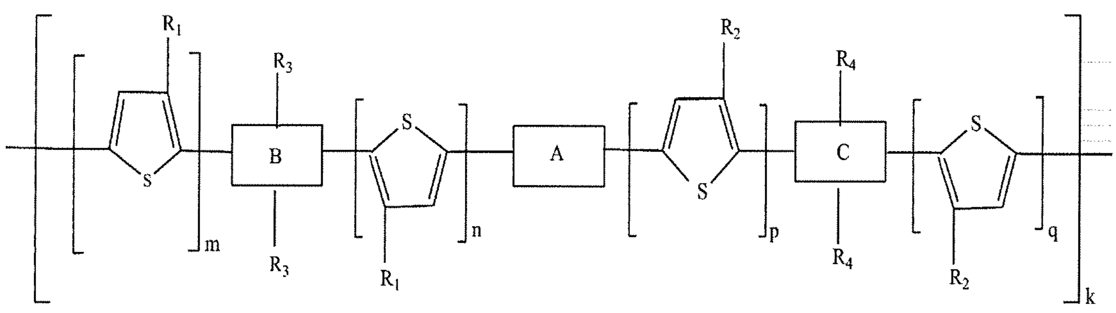

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,

wherein k represents the number of repeating units of from 1 to about 200; A is a divalent linkage; and B and C are

independently selected from the group consisting of a bond, a divalent linkage, and combinations thereof, wherein m, n, p and q each individually represent from 0 to about 20,
wherein if the both B and C are thieno[3,2-*b*]thiophene, m and n cannot be 1 and p and q cannot be 1, and
wherein $R_1$, $R_2$, $R_3$ and $R_4$ are arranged in a manner promoting high mobility and providing a weak side chain interaction,
the method comprising:

forming the gate electrode and gate dielectric layer ,
depositing the semiconductor compound of formula 1 on the substrate to form an active layer of the semiconductor compound on the surface of the substrate,
wherein no high-temperature annealing is conducted following the formation of the active layer of the semiconductor compound; and
depositing the source electrode and the drain electrode.

(25) The method according to (24), wherein the annealing temperature for the thin-film transistor is below about 150 °C.
(26) The method according to (24), wherein the annealing temperature for the thin-film transistor is below about 100 °C.
(27) The method according to (24), wherein the thin-film transistor has a mobility greater than 0.1 $cm^2/V \cdot s$.

BRIEF DESCRIPTION OF FIGURES

Illustrated in Figures 1 and 2 are various representative embodiments of the present disclosure, and wherein polymer semiconductors of the formulas as illustrated herein are selected as the semiconductor material in thin film transistor (TFT) configurations.

Illustrated in Figure 3 is the repeating distance between adjacent side chains and side chain interdigitation of the PQT semiconductor polymer.

Illustrated in Figure 4 is a polymer semiconductor of the formulas as illustrated herein, wherein the repeating distance between two adjacent side chains is narrowed to 9.3 angstroms and thus does not allow for the side chains from another polymer to enter the this narrowed space and form any interdigitation interaction.

Illustrated in Figure 5 is a polymer semiconductor of the formulas as illustrated herein, wherein the repeating distance between two adjacent side chains is widened to 16.1 angstroms. Although the widened side chain distance could allow side from another polymer to enter the space, the interaction between the side chains from different polymer molecules is weak since the interdigitation is very loose.

EMBODIMENTS

In embodiments, the polymer semiconductor can be represented by formulas (1) through (6).

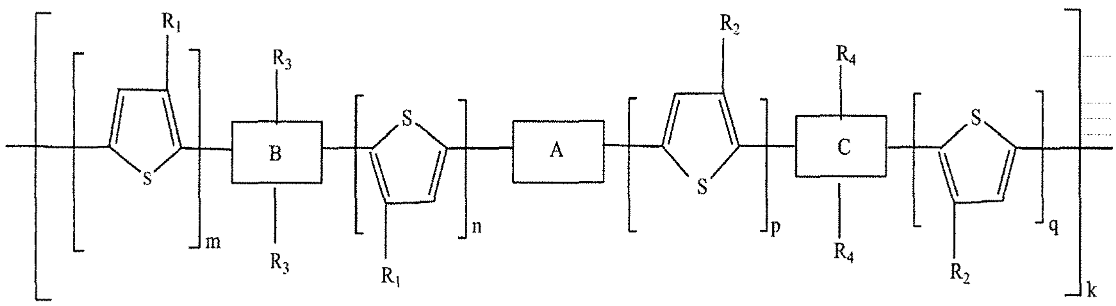

(1)

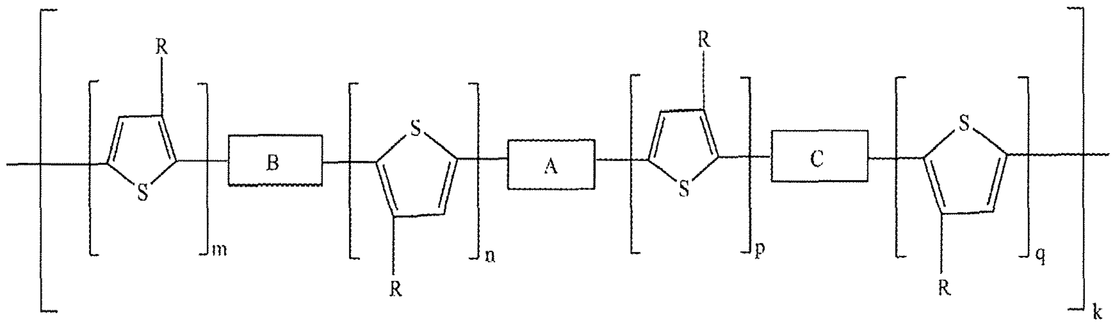

(2)

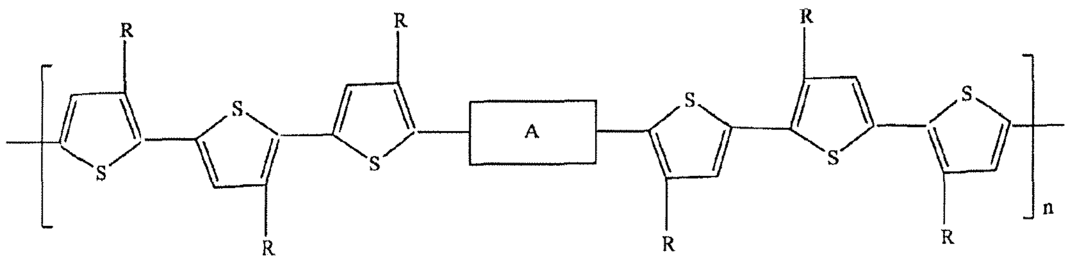

(3)

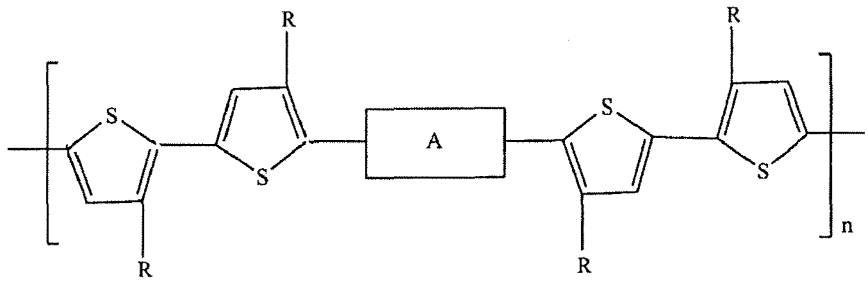

(4)

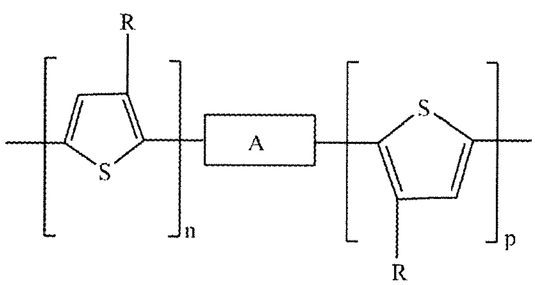

(5)

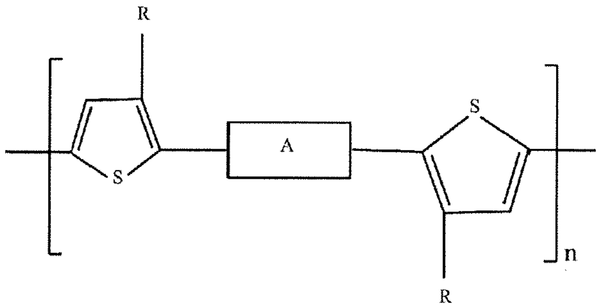

(6)

wherein each R, $R_1$, $R_2$, $R_3$ and $R_4$ can be a hydrogen atom, a hydrocarbon group, a heteroatom, m, n, p and q can represent the number of thienylene units of from about 1 to about 5000, of from about 2 to about 3000 or from about 5 to about 1000, from about 5 to about 800, from about 5 to about 200 or from about 5 to about 75; k can represent the number of repeating units of from about 1 to about 5000, of from about 2 to about 3000 or from about 5 to about 1000, from about 5 to about 800, from about 5 to about 200 or from about 5 to about 75. Formula 1 represents the generic structure of the polymer semiconductor compounds.

Unless otherwise indicated, in identifying the substituents for R, R', $R_1$, $R_2$, $R_3$ and $R_4$, the phrase "hydrocarbon group" encompasses both unsubstituted hydrocarbon groups and substituted hydrocarbon groups. The unsubstituted hydrocarbon group may contain, for example, from about 1 to about 50 carbon atoms, from about 5 to about 40 carbon atoms or from about 10 to about 35 carbon atoms. However, at least one substituent, $R_1$, $R_2$, $R_3$ and $R_4$ , in the polymer semiconductor compound must not be a hydrogen atom. Examples of the unsubstituted hydrocarbon groups may include, for example, a straight chain alkyl group, a branched alkyl group, a cycloalkyl group, an aryl group, an alkylaryl group, and an arylalkyl group. Example alkyl groups may include, for example, methyl, ethyl, propyl, butyl, pentyl, hexyl, heptyl, octyl, nonyl, decyl, undecyl, dodecyl, tridecyl, tetradecyl, pentadecyl, cyclopentyl, cyclohexyl, cycloheptyl, and isomeric forms thereof.

The substituted hydrocarbon group may contain, for example, from about 1 to about 70 carbon atoms, from about 10 to about 60 carbon atoms and from about 20 to about 50 carbon atoms substituted with, for example, fluorine, bromine, chlorine, iodine, sulfur, amino, nitro, cyano, methoxyl, ethoxyl, propoxy, or combinations thereof. Substituted hydrocarbon groups may be, for example, a straight chain alkyl group, a branched alkyl group, a cycloalkyl group, an aryl group, an alkylaryl group, and an arylalkyl group with a heteroatom. Example alkyl groups may include, for example, methyl, ethyl, propyl, butyl, pentyl, hexyl, heptyl, octyl, nonyl, decyl, undecyl, dodecyl, tridecyl, tetradecyl, pentadecyl, cyclopentyl, cyclohexyl, cycloheptyl, and isomeric forms thereof. In embodiments, the hydrocarbon group may be optionally substituted alkyl and optionally substituted aryl.

Unless otherwise indicated, in identifying the substituents for R, R', $R_1$, $R_2$, $R_3$ and $R_4$, the term "heteroatom" includes fluorine, bromine, chlorine, iodine, sulfur, nitrogen, oxygen, or combinations thereof. Further the heteroatom can be a single atom such as, for example, chlorine or fluorine or the single atom contained in a compound such as, for example, the nitrogen atom (N) in an amino compound ($NH_2$) and the sulfur atom (S) in a $SO_2$ compound.

In embodiments, the polymer semiconductor may have a symmetrical repeating unit. As used herein, the term "symmetrical repeating unit" refers to a polymer semiconductor with the same substituent or hydrocarbon group repeated in a symmetrical fashion down the backbone of the polymer semiconductor.

The number average molecular weight ($M_n$) of the polymers can be, for example, from about 500 to about 400,000, including from about 1,000 to about 150,000, and the weight average molecular weight ($M_w$) can be from about 600 to about 500,000, including from about 1,500 to about 200,000, both as measured by gel permeation chromatography using polystyrene standards.

In embodiments, A is a conjugated fused-ring divalent linkage. The fused ring divalent linkage has at least 8 electrons to form a pi-conjugation. For example from 8 to 30 electrons, or from 10 to 20 electrons to form a pi-conjugation. In embodiments, the pi-conjugation of the fused ring is extended perpendicular to the backbone.

In further embodiments, A in the polymer semiconductor compound can be selected from any divalent linkage having at least 4 carbon atoms, such as, for example, from about 4 to about 40 carbon atoms, from about 6 to about 30 carbon atoms, from about 8 to about 24 carbon atoms and from about 8 to about 16 carbon atoms. Examples of divalent linkage may include, for example,

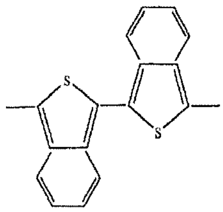 , 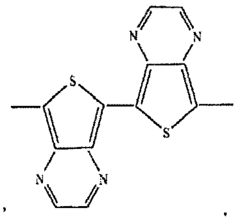 , 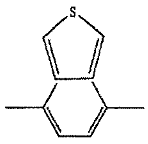 ,

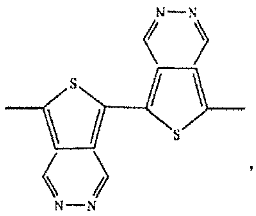 , 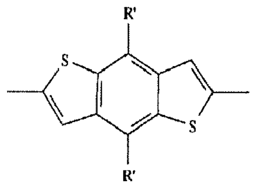 , 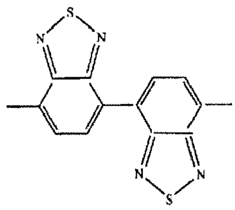 ,

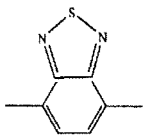 , 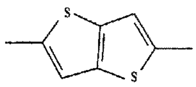 , 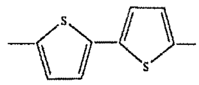

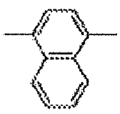 , 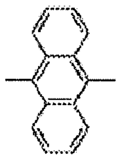 , 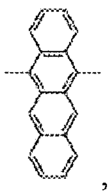 , 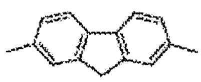 , 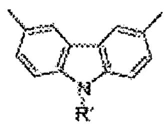 ,

or combinations thereof. Examples of R' may include a hydrogen atom, hydrocarbon group, heteroatom or combinations thereof.

In even further embodiments, B and C in the polymer semiconductor compound can be selected from a bond and any divalent linkage having at least 4 carbon atoms, such as, for example, from about 4 to about 40 carbon atoms, from about 6 to about 30 carbon atoms, from about 8 to about 24 carbon atoms and from about 8 to about 16 carbon atoms. Examples of divalent linkage may include, for example,

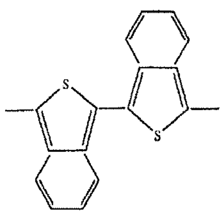 , 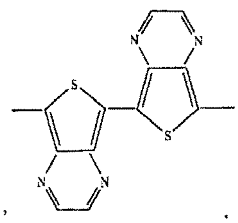 , 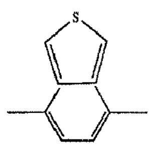 ,

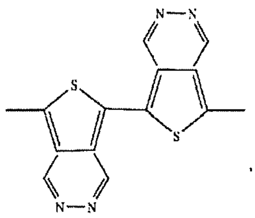, 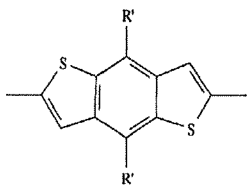, 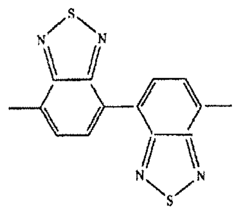,

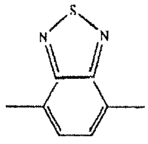, 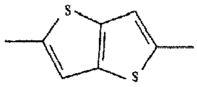, 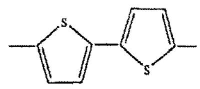

—CH=CH—, —C≡C—, 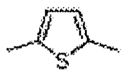, 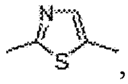, 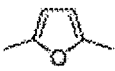, 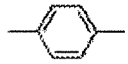, 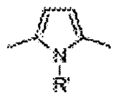,

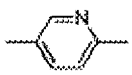, 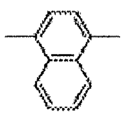, 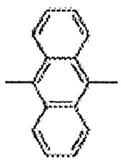, 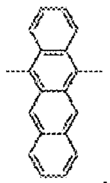, 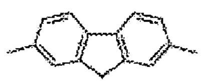, 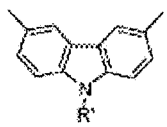,

or combinations thereof. Examples ofR' may include a hydrogen atom, hydrocarbon group, heteroatom or combinations thereof.

As used herein, the phrase "bond" between the substituents of the polymer semiconductor is a chemical bond. The chemical bond can take the form of, for example, covalent bonding, hydrogen bonding, coordination complex bonding, or ionic bonding, or a mixture of different chemical bondings. In embodiments, the bond is a covalent bond.

In embodiments, if both B and C are thieno[3,2-*b*]thiophene,

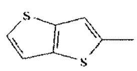,

the number of repeating units characterized as m and n of Formula 1 and Formula 2 both cannot equal 1. Further, if both B and C are thieno[3,2-*b*]thiophene

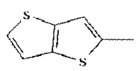,

the number of repeating units characterized as p and q of Formula 1 and Formula 2 both cannot equal 1.

The polymer semiconductor can be arranged in any combination of copolymer or unsymmetrical repeating units, except where two substituents or hydrocarbon groups are present at the 3 and 3' positions for any two adjacent thiophene units within the structure of the polymer semiconductor, as further illustrated by the figure below.

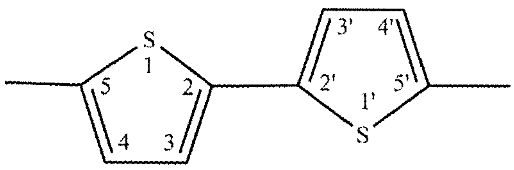

In other words, simultaneous substitutions at the third ring positions (3 and 3') of two adjacent thiophene units are not allowed. The simultaneous presence of substituents at the third ring positions may cause torsional deviation of the two adjacent thiophene units from coplanarity, and thus significantly shorten the pi-conjugation of the polymer semiconductor. Shortening the pi-conjugation may lead to short pi-delocalization and thus resulting in both poor charge carrier transport capability and low mobility.

In further embodiments, the structures of formulas (1) and (2) of the polymer semiconductor can be arranged in any manner that promotes high mobility due to a weak side chain interaction and does not require high-temperature thermal annealing. As used herein, the phrase "high mobility" is any mobility of the polymer semiconductor compound greater of 0.1 $cm^2/V \cdot s$, which, as stated above, is the upper limit of the mobility for the PQT compound.

The weak side chain interaction within the polymer semiconductor may be achieved by 1) narrowing the repeating distance of the side chains resulting in no side chain interdigitation, 2) widening the repeating distance between the side chains to form a very loose side chain interdigitation, or 3) substituting a bulky hydrocarbon group perpendicular to the backbone of the polymer semiconductor.

Figure 3 illustrates the repeating distance between adjacent side chains and side chain interdigitation of the poly[5.5'-bis(3-dodecyl-2-thienyl)-2,2'-bithiophene] (PQT) semiconductor polymer. As seen in Figure 3, the distance between the adjacent two side chains at one side of the polymer backbone is about 12 angstroms. This distance is sufficient enough to allow one alkyl side of another polymer to enter this space and form an interdigitation interaction. In this case, the PQT semiconductor has a strong side chain interaction. In terms of thermal properties, a side chain phase transition, such as side chain melting, could be observed in Digital Scanning Colormeter (DSC) thermal diagram.

In embodiments, the polymer semiconductor does not achieve this undesired strong side chain interaction so long as the side chains are arranged in a manner results in a weak side chain interaction. In terms of thermal properties of the polymer semiconductor, there is no side chain phase transition in its DSC thermal diagram such as, for example, side chain melting.

In embodiments, the weak side chain interaction of the polymer semiconductor may be achieved by narrowing the repeating distance between the side chains so that there is no side-chain interdigitation. Figure 4 illustrates a polymer semiconductor

wherein the repeating distance between the side chains is narrowed to a distance of 9.3 angstroms, which is less than that of PQT (12 angstroms). This distance is too small to allow a side chain from another polymer to enter the space and form any interdigitation interaction. In other words, this scenario embodies "no side chain interdigitation".

In embodiments, the side chains on the polymer semiconductor may be narrowed to a distance of from about 10 angstroms to about 4.5 angstroms and from about 8 angstroms to about 5 angstroms. It is understood that this distance may change depending on the side chain distribution manner. For example, if a space is needed to adopt two side chains at the same time as shown in the example above, the required distance to avoid side chain interdigitation may be different from above.

The weak side chain interaction of the polymer semiconductor may also be achieved by widening the repeating distance between the side chains so as to promote loose interdigitation. As seen from Figure 5, the distance between two adjacent side chains is about 16.1 angstroms, which is larger than that of PQT (12 angstroms).

Therefore, if a side chain from another polymer entered this space, the interaction among the side chains would be too weak to form an interdigitation interaction.

In embodiments, the loose interdigitation may be the widening of the distance between the side chains to a distance of from about 14 angstroms to about 50 angstroms and from about 16 angstroms to about 25 angstroms.

The weak side chain interaction may also be achieved by substituting a bulky hydrocarbon group perpendicular to the backbone of a polymer semiconductor. As used herein, the word "bulky" in the phrase bulky hydrocarbon group is any hydrocarbon group containing at least 10 carbon atoms such as, for example, from about 10 to about 500 carbon atoms, from about 20 to about 200 carbon atoms, from about 30 to about 100 carbon atoms and from about 40 to about 75 carbon atoms.

In embodiments, a polymer semiconductor with a "fused aromatic" or increased pi conjugation extended perpendicular to the backbone increases the solubility and promotes crystallinity. The solubility of the polymer semiconductor may increase from a factor of about 1.5 to about 3, from about 1.75 to about 2.75 and from about 2.0 to about 2.25. The crystallinity of the polymer semiconductor may increase by a factor of 1.5 to about 3, from about 1.75 to about 2.75 and

from about 2.0 to about 2.25. As used herein, the phrase "fused aromatic" may be defined as any two aromatic compounds linked by a shared C-C bond. Examples may include the following aromatic compounds or mixtures thereof:

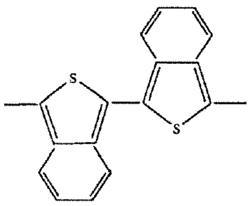,
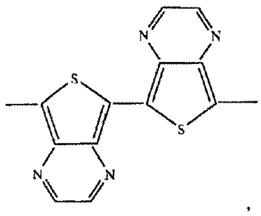,
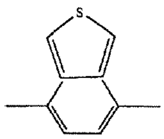,

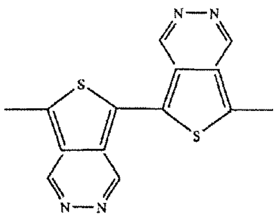,
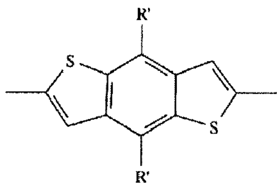,
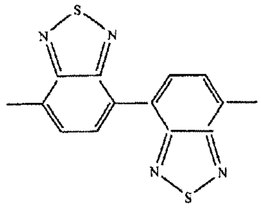,

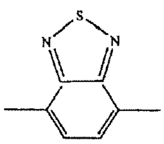,
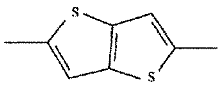,
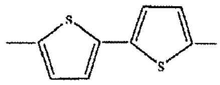

A polymer semiconductor with a weak side chain interaction promotes high mobility without the need for a high temperature annealing temperature to reorder the polymer backbones. However, if annealing is required, the annealing temperature for the polymer semiconductor may be below about 180 °C, such as, for example, below about 150 °C below about 100 °C, below about 75 °C or below about 50 °C.

The polymer semiconductors of Formula (1) are soluble or substantially soluble in common coating solvents, for example, in embodiments they possess a solubility of at least about 0.1 percent by weight, and more specifically, from about 0.5 percent to about 10 percent, or to about 50 percent by weight in such solvents as methylene chloride, 1,2-dichloroethane, tetrahydrofuran, toluene, xylene, mesitylene, chlorobenzene, dichlorobenzene, and the like. Moreover, the polymer semiconductors of the formulas as illustrated herein provide a stable conductivity of, for example, from about $10^{-9}$ S/cm to about $10^{-4}$ S/cm, and more specifically, from about $10^{-8}$ S/cm to about $10^{-5}$ S/cm as determined by conventional four-probe conductivity measurements.

In yet other embodiments, there is provided a thin-film transistor comprising:

(a) a gate dielectric layer;
(b) a gate electrode;
(c) a semiconductor layer;
(d) a source electrode;
(e) a drain electrode; and
(f) a substrate layer

wherein the gate dielectric layer, the gate electrode, the semiconductor layer, the source electrode, the drain electrode and the substrate layer are in any sequence as long as the gate electrode and the semiconductor layer both contact the gate dielectric layer, and the source electrode and the drain electrode both contact the semiconductor layer, and the semiconductor layer is comprised of the polymer semiconductor compounds described herein.

In embodiments and with further reference to the present disclosure, the substrate layer may generally be a silicon material inclusive of various appropriate forms of silicon, a glass plate, a plastic film or a sheet, and the like depending on the intended applications. For structurally flexible devices, a plastic substrate, such as for example polyester, polycarbonate, polyimide sheets, and the like, may be selected. The thickness of the substrate may be, for example, from about 10 micrometers to about 100 millimeters with a specific thickness being from about 50 to about 100 micrometers, especially for a flexible plastic substrate, and from about 1 to about 10 millimeters for a rigid substrate such as

glass or silicon.

The gate dielectric layer, which can separate the gate electrode from the source and drain electrodes, and in contact with the semiconductor layer, can generally be an inorganic material film, an organic polymer film, or an organic-inorganic composite film. The thickness of the gate dielectric layer can be, for example, from about 10 nanometers to about 1 micrometer with a more specific thickness being about 100 nanometers to about 500 nanometers. Examples of inorganic materials suitable as the dielectric layer may include silicon oxide, silicon nitride, aluminum oxide, barium titanate, barium zirconate titanate and the like. Examples of organic polymers for the dielectric layer may include polyesters, polycarbonates, poly(vinyl phenol), polyimides, polystyrene, poly(methacrylate)s, poly(acrylate)s, epoxy resin and the like. Examples of inorganic-organic composite materials may include nanosized metal oxide particles dispersed in polymers, such as polyester, polyimide, epoxy resin and the like. The gate dielectric layer is generally of a thickness of from about 50 nanometers to about 500 nanometers depending on the dielectric constant of the dielectric material used. More specifically, the dielectric material has a dielectric constant of, for example, at least about 3, thus a suitable dielectric thickness of about 300 nanometers can provide a desirable capacitance, for example, of about $10^{-9}$ to about $10^{-7}$ $F/cm^2$.

Situated, for example, between and in contact with the dielectric layer and the source/drain electrodes is the active semiconductor layer comprised of polymer semiconductors of the formulas as illustrated herein, and wherein the thickness of this layer is generally, for example, about 10 nanometers to about 1 micrometer, or about 40 to about 100 nanometers. This layer can generally be fabricated by solution processes such as spin coating, casting, screen, stamp, or jet printing of a solution of polymer semiconductors of the present disclosure.

The gate electrode can be a thin metal film, a conducting polymer film, a conducting film generated from a conducting ink or paste, or the substrate itself (for example heavily doped silicon). Examples of the gate electrode materials may include gold, chromium, indium tin oxide, conducting polymers, such as polystyrene sulfonate-doped poly (3,4-ethylenedioxythiophene) (PSS/PEDOT), a conducting ink/paste comprised of carbon black/graphite or colloidal silver dispersion contained in a polymer binder, such as Electrodag available from Acheson Colloids Company, and silver filled electrically conductive thermoplastic ink available from Noelle Industries, and the like. The gate layer may be prepared by vacuum evaporation, sputtering of metals or conductive metal oxides, coating from conducting polymer solutions or conducting inks, or dispersions by spin coating, casting or printing. The thickness of the gate electrode layer may be, for example, from about 10 nanometers to about 10 micrometers, and a specific thickness may be, for example, from about 10 to about 200 nanometers for metal films, and about 1 to about 10 micrometers for polymer conductors.

The source and drain electrode layer can be fabricated from materials which provide a low resistance ohmic contact to the semiconductor layer. Typical materials suitable for use as source and drain electrodes may include those of the gate electrode materials such as gold, nickel, aluminum, platinum, conducting polymers, and conducting inks. Typical thickness of this layer may be, for example, from about 40 nanometers to about 1 micrometer with the more specific thickness being about 100 to about 400 nanometers. The TFT devices contain a semiconductor channel with a width W and length L. The semiconductor channel width may be, for example, from about 10 micrometers to about 5 millimeters with a specific channel width being about 100 micrometers to about 1 millimeter. The semiconductor channel length may be, for example, from about 1 micrometer to about 1 millimeter with a more specific channel length being from about 5 micrometers to about 100 micrometers.

The source electrode is grounded and a bias voltage of generally, for example, about 0 volts to about -80 volts is applied to the drain electrode to collect the charge carriers transported across the semiconductor channel when a voltage of generally, for example, about +10 volts to about -80 volts is applied to the gate electrode.

In embodiments, the annealing temperature for a thin-film transistor comprised of a polymer semiconductor layer having the polymer semiconductor compounds according to the Formulas herein is about or below about 150 °C, about or below about 125 °C or about or below about 100 °C.

Figure 1 illustrates a TFT configuration comprised of a substrate (16) in contact with a gate electrode (18) and with a gate dielectric layer (14) containing the gate electrode (18). On top of the gate dielectric layer (14) are the source electrode (20) and the drain electrode (22). Above and situated between the source electrode (20) and the drain electrode (22) is the polymer semiconductor layer (12). The gate electrode (18) can be included in the substrate (16), in the gate dielectric layer (14), and the like throughout.

Figure 2 illustrates a TFT configuration comprised of a substrate (16) in contact with a gate electrode (18) and with a gate dielectric layer (14) containing the gate electrode (18). On top of the gate dielectric layer (14) is the polymer semiconductor layer (12). Above the polymer semiconductor layer (12) are the source electrode (20) and the drain electrode (22).

Other known suitable materials not recited herein for the various components of the TFT devices of the present disclosure can also be selected in embodiments.

EXAMPLE 1

The synthesis reaction for poly(4,8-didodecyl-2,6-bis-(3-methylthiophen-2-yl)-benzo[1,2-b:4,5-b']dithiophene), a polymer semiconductor according to Formula 1, can be represented the following diagram. This polymer has a weak side chain interaction due to wide side chain spacing.

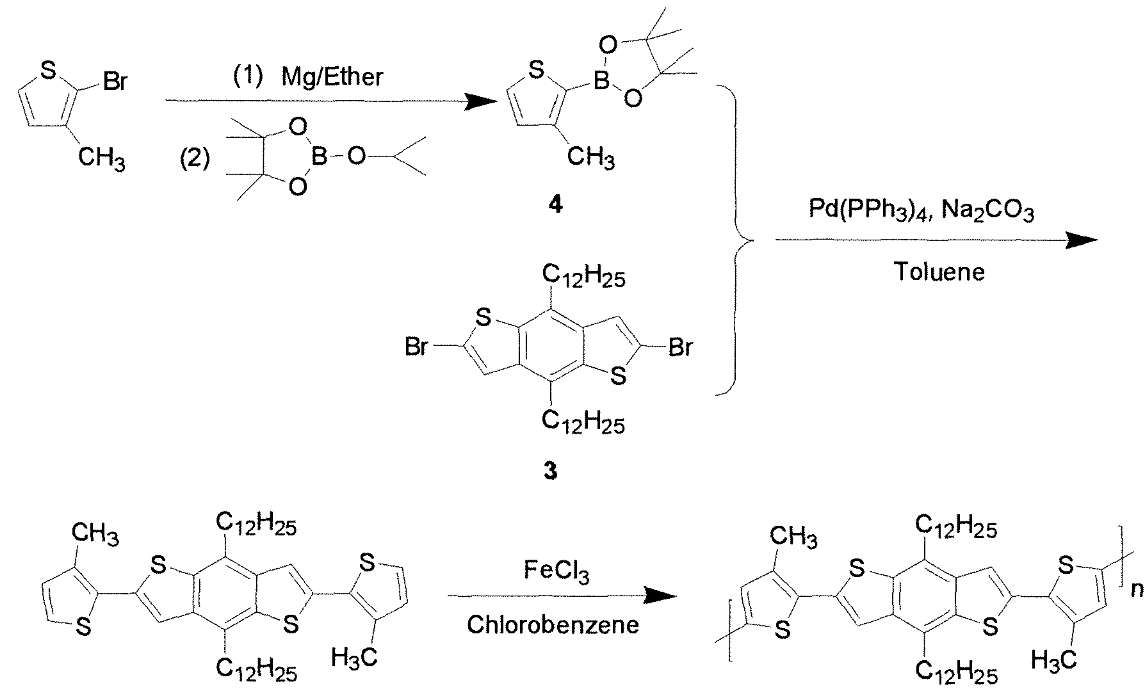


4

3

5

2a

Formation of Methylthiophene-2-boronic acid pinacol ester (4)

A 100 mL three-necked round-bottomed flask was flushed with argon gas and then evacuated under reduced pressure with heating. This procedure was repeated twice before magnesium turnings (1.65 g, 67.8 mmol) were added. After the flask was again flushed with argon for 10 minutes, 10 mL of anhydrous ether was added with stirring and followed by the slow addition of 5 mL solution of 2-bromo-3-methylthiophene (10.0 g, 56.5 mmol) in 20 mL anhydrous ether. The reaction mixture was slightly heated with a heat gun to initiate reaction that occurred about 3 minutes later with gas evolution. Subsequently, all the remaining 2-bromo-3-methylthiophene solution was added, and the reaction was allowed to proceed at room temperature for another 2 hours.

The resulting reaction mixture was transferred to another 100 mL flask and cooled to -78 °C, after which 2-isopropoxy-4,4,5,5-tetramethyl-1,3,2-dioxaborolane (17.3 mL, 169.5 mmol) was added by a syringe. After stirring the resulting solution at room temperature for 18 hours, 15 mL of water was added to the reaction mixture and the organic and aqueous layers were separated. The aqueous portion was extracted with $CH_2Cl_2$ (3 × 50 mL), and the extract combined with the organic portion, dried with anhydrous $MgSO_4$ and evaporated to dryness. Purification of the residue via column chromatography on silica gel (fluent: hexane/dichloromethane, 4/1, v/v) yielding 10.1 grams (Yield: 80%) of pure product as white powder after drying in vacuum.

Formation of 8-Didodecyl-2,6-bis-(3-methylthiophen-2-yl)-benzo[1,2-b:4,5-b']dithiophene (5)

To a 100 mL 3-necked reaction flask 1.0 g (1.46 mmol) of 2,6-dibromo-4,8-didodecylbenzo[1,2-b:4,5;b']dithiophene, 0.82 g (3.65 mmol) of 3-methylthiophene-2-boronic acid pinacol ester, and 25 mL of toluene were added. The resulting mixture was stirred and purged with argon before a mixture of 0.034 g of tetrakis(triphenylphosphine palladium (0)) ($Pd(Ph_3P)_4$), 0.36 g of Aliquat in 5 mL toluene, and 4.2 mL of 2 M aqueous $Na_2CO_3$ was added. Subsequently, the reaction mixture was heated at 105 °C for 26 hours with stirring and cooled to room temperature.

Next, 100 mL of toluene was added and the organic layer was separated and washed 3 times with water, dried over anhydrous $MgSO_4$, and filtered. After evaporation, the filtrate gave a solid residue, which was purified by column

chromatography on silica gel (eluent: hexane/dichloromethane, 7/1, v/v) and then further recrystallized from 2-propanol to yield 0.57 grams of pure product (Yield: 57%) as a yellow needle-like crystal.

Formation of Poly(4,8-didodecyl-2,6-bis-(3-methylthiophen-2-yl)-benzo[1,2-b:4,5-b']dithiophene) (2a):

A solution of 0.41 g 4,8-didodecyl-2,6-bis-(3-methylthiophen-2-yl)benzo[1,2-b:4,5-b']dithiophene in 10 mL of chlorobenzene was added dropwise to a well-stirred mixture of 0.46 g $FeCl_3$ in 10 mL of chlorobenzene in a 50 mL round-bottom flask under an argon atmosphere over a period of 1 minute. The resulting mixture was heated to 65 °C and maintained at this temperature for 48 hours under a blanket of argon.

After cooling down to room temperature, 15 mL of chlorobenzene was added. The resulting mixture was poured into 200 mL of methanol, and ultrasonicated for 20 minutes before being stirred at room temperature for 1 hour to form the precipitate. The precipitated product was filtered and added to a well-stirred mixture of 200 mL methanol and 50 mL 30% aqueous ammonia solution. Next, the precipitated product was ultrasonicated again for 5 minutes and stirred at room temperature for 3 days to form a sold. The solid was filtered and subjected to Soxhlet extraction with methanol and then with heptane to remove low molecular weight materials. The remaining solid residue was extracted with 200 mL chlorobenzene for 16 hours to give a brown chlorobenzene extract yielding 0.12 g (yield 46%) of pure brown metallic-like polymer semiconductor upon solvent removal and drying in a vacuo.

Device Fabrication and Evaluation

Bottom-gate, top-contact TFT test devices with poly(4,8-didodecyl-2,6-bis-(3-methylthiophen-2-yl)-benzo[1,2-b:4,5-b']dithiophene) as the semiconductor layer were prepared on silicon wafer in ambient conditions without taking any special precautions to exclude air, moisture and ambient light. A heavily n-doped silicon wafer with a 200 nm top layer of thermal silicon dioxide ($SiO_2$) was used as the substrate/gate electrode with the $SiO_2$ top layer serving as the gate dielectric. After cleaning the $SiO_2$ surface of the wafer with oxygen plasma, the cleaned wafer was immersed in a 0.1 M solution of octyltrichlorosilane (OTS-8) in toluene at 60 °C for 30 minutes. The wafer was then rinsed with toluene and 2-propanol, and then air-dried.

The polymer semiconductor layer was then deposited on top of silane-treated $SiO_2$ surface by spin coating a warm solution (- 50 °C) of poly(4,8-didodecyl-2,6-bis-(3-methylthiophen-2-yl)-benzo[1,2-b:4,5-b']dithiophene) in 1,2-dichlorobenzene (0.5 weight %) at 1000 rpm for 30 seconds and vacuum drying the substrate at 70 °C for 10 minutes to form a 40-100 nm-thick polymer semiconductor layer. No thermal annealing was applied. Subsequently, a series of gold source/drain electrode pairs were deposited on the surface of the polymer semiconductor layer by vacuum evaporating through a shadow mask. This creates a series of TFTs with various channel length (L) and width (W) dimensions. The resulting TFT devices with channel lengths of 40, 90 or 190 $\mu$m and channel widths of 1 or 5 mm TFTs were patterned and characterized on a Keithley SCS-4200 in a black metal box in air.

The FET mobility was extracted using the following equation in the saturation regime from the gate sweep:

$$I_D = \mu C_i (V_G - V_T)^2 \ (W/2L)$$

where $I_D$ is the drain current, $\mu$ is the field-effect mobility, $C_i$ is the capacitance per unit area of the gate dielectric layer ($SiO_2$ 200 nm, $C_i$ = 15 nF $cm^{-2}$), and $V_G$ and $V_T$ are respectively gate voltage and threshold voltage. $V_T$ was derived from the relationship between the square root of $I_D$ at the saturated regime and $V_G$ by extrapolating the measured data to $I_D$ = 0. W and L are respectively channel width and length. The TFT device showed a mobility 0.15 $cm^2/V{\cdot}s$ and a current on/off ratio $10^6$.

It will be appreciated that various of the above-disclosed and other features and functions, or alternatives thereof, may be desirably combined into many other different systems or applications. Also, various presently unforeseen or unanticipated alternatives, modifications, variations or improvements therein may be subsequently made by those skilled in the art, and are also intended to be encompassed by the following claims.

**Claims**

**1.** A polymer semiconductor compound of Formula 1,

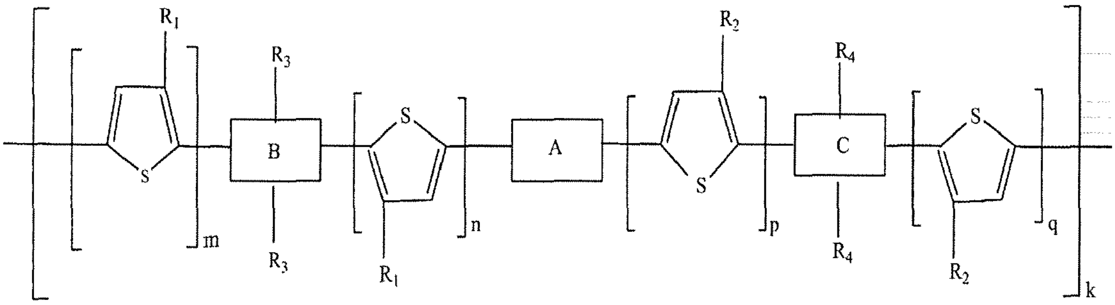

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,
wherein k represents the number of repeating units of from 1 to about 200; A is a divalent linkage; and B and C are independently selected from the group consisting of a bond, a divalent linkage, and combinations thereof,
wherein m, n, p and q each individually represent from 0 to about 20,
wherein if the both B and C are thieno[3,2-*b*]thiophene, m and n cannot be 1 and p and q cannot be 1, and
wherein $R_1$, $R_2$, $R_3$ and $R_4$ are arranged in a manner promoting high mobility and providing a weak side chain interaction.

**2.** A polymer semiconductor compound according to claim 1, wherein $R_1$, $R_2$, $R_3$ and $R_4$ extend perpendicular to the backbone of the polymer semiconductor.

**3.** A polymer semiconductor compound according to claim 1, wherein substituting a fused aromatic to the backbone of the polymer semiconductor increases the crystallinity of the polymer semiconductor by a factor of at least about 1.5.

**4.** A polymer semiconductor compound according to claim 3, wherein the fused aromatic has an extended pi-conjugation perpendicular to the backbone of the polymer semiconductor.

**5.** A polymer semiconductor compound according to claim 3, wherein the fused aromatic is

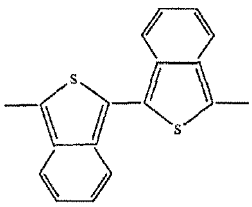 , 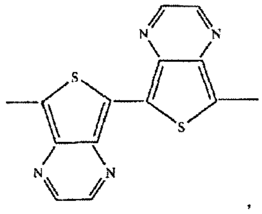 , 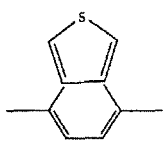 ,

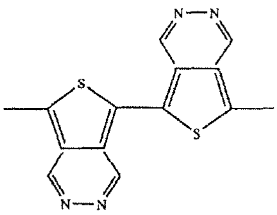 , 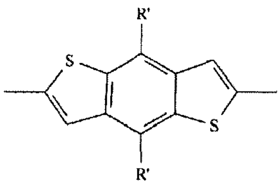 , 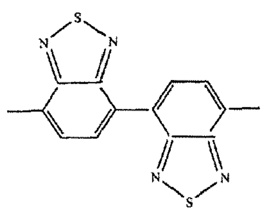 ,

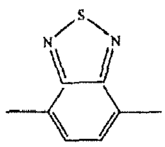 , 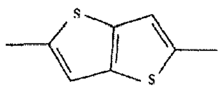 , 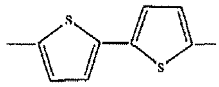

or mixtures thereof.

6. A polymer semiconductor compound according to claim 1, wherein at least one $R_1$, $R_2$, $R_3$ and $R_4$ is a hydrocarbon group.

7. A polymer semiconductor compound according to claim 6, wherein the hydrocarbon group is an unsubstituted hydrocarbon comprising from 1 to about 30 carbon atoms selected from a group consisting of a straight chain alkyl group, branched alkyl group, cycloalkyl group, aryl group, alkylaryl group, arylalkyl group and combinations thereof.

8. A polymer semiconductor compound according to claim 6, wherein the hydrocarbon group is a substituted hydrocarbon comprising 1 to about 40 carbon atoms and selected from a group consisting of straight chain alkyl group, branched alkyl group, cycloalkyl group, aryl group, alkylaryl group, arylalkyl group and combinations thereof and substituted one or more times with chlorine, bromine, fluorine, iodine, sulfur, amino, nitro, cyano, methoxyl, ethoxyl, and propoxyl.

9. A polymer semiconductor compound according to claim 1, wherein the divalent linkage of A is independently selected from a group consisting of:

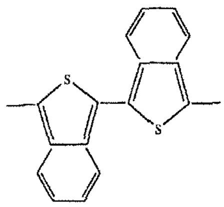 , 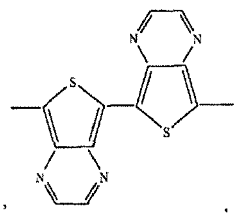 , 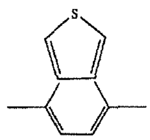 ,

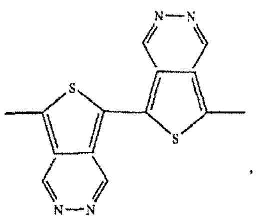 , 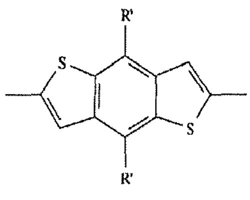 , 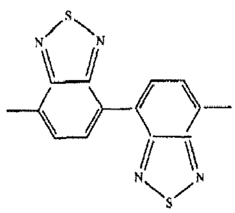 ,

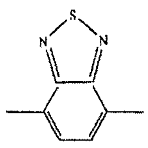 , 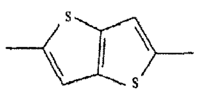 , 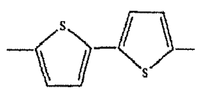

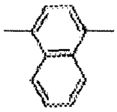, 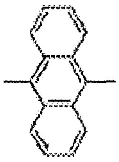, 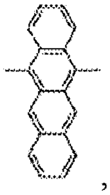, 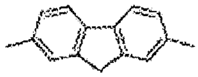, 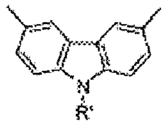,

and combinations thereof, and wherein the divalent linkage of B and C is independently selected from a group consisting of:

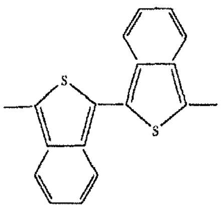, 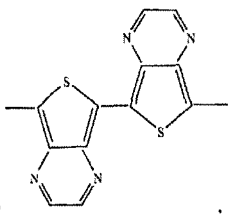, 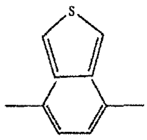,

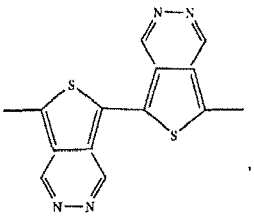, 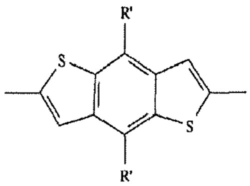, 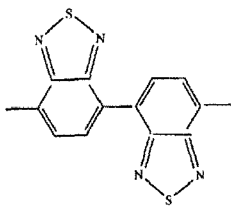,

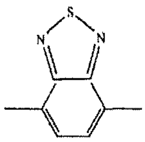, 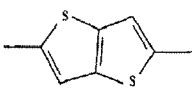, 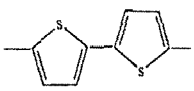

—CH=CH—, —C≡C—, 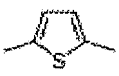, 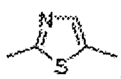, 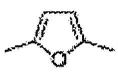, 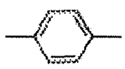, 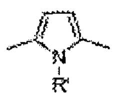,

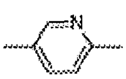, 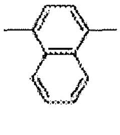, 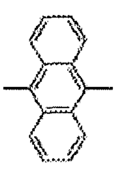, 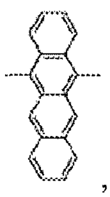, 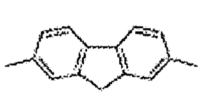, 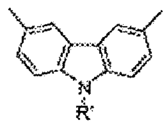

and combinations thereof.

**10.** A polymer semiconductor compound according to claim 1, wherein the chemical structure of the polymer semiconductor compound has a formula selected from a group consisting of:

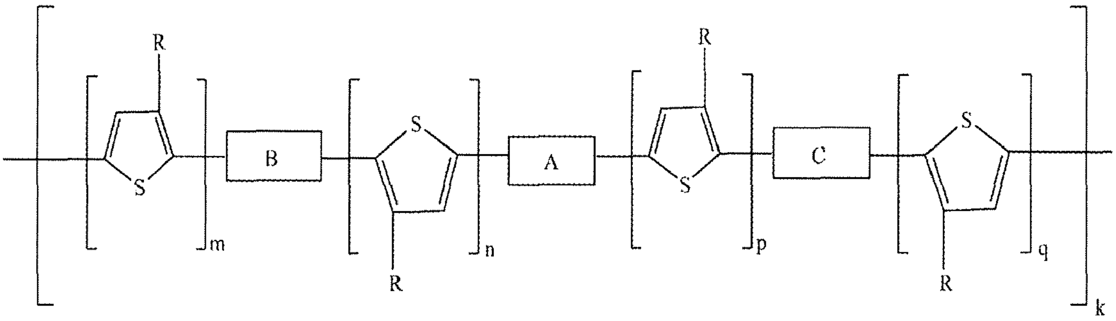

(2)

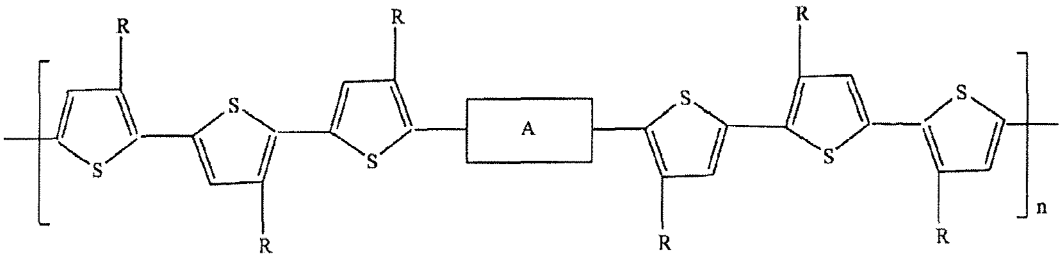

(3)

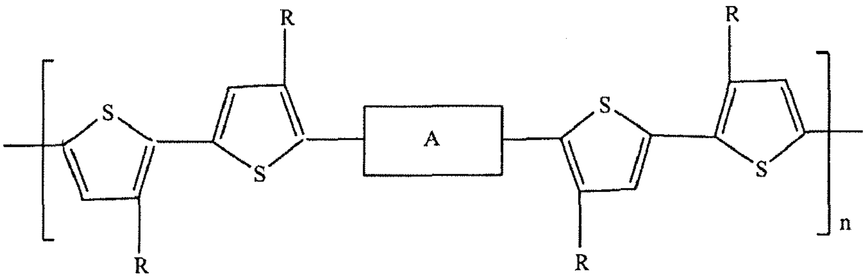

(4)

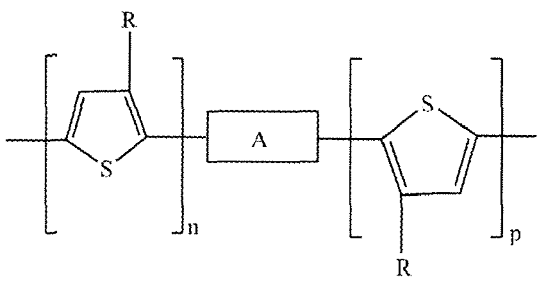

(5)

and

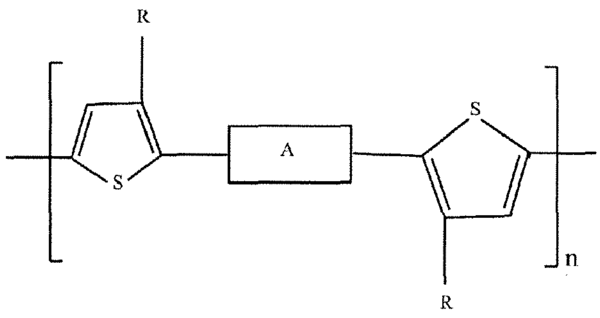

(6)

wherein R is a side chain arranged perpendicular to the backbone of the polymer semiconductor, to promote high mobility and to a provide weak side chain interaction.

**11.** A polymer semiconductor compound according to claim 1, wherein the mobility of the polymer semiconductor compound is greater than 0.1 $cm^2/V \cdot s$.

**12.** A thin-film transistor comprised of a polymer semiconductor layer having a polymer semiconductor compound of Formula 1,

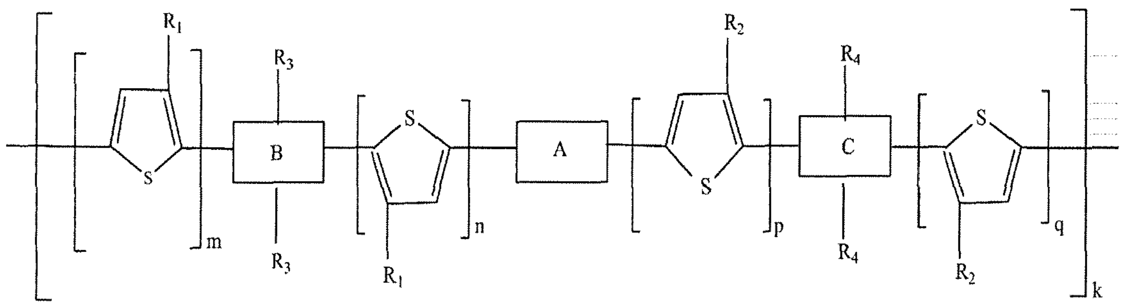

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,
wherein k represents the number of repeating units of from 1 to about 200; A is a divalent linkage; and B and C are independently selected from the group consisting of a bond, a divalent linkage, and combinations thereof,
wherein m, n, p and q each individually represent from 0 to about 20,
wherein if the both B and C are thieno[3,2-*b*]thiophene, m and n cannot be 1 and p and q cannot be 1, and
wherein $R_1$, $R_2$, $R_3$ and $R_4$ are arranged in a manner promoting high mobility and providing a weak side chain interaction.

**13.** A thin-film transistor according to claim 12, wherein the polymer semiconductor has a symmetric repeating unit and the polymer semiconductor has a weak side chain interaction due to no side chain interdigitation.

**14.** A thin-film transistor according to claim 12, wherein thin-film transistor has a mobility greater than 0.1 $cm^2/V \cdot s$.

**15.** A method of manufacturing a thin-film transistor, which comprises a substrate, a gate electrode, a gate dielectric layer, an insulating layer, a source electrode and a drain electrode and in contact with the source/drain electrodes and the gate dielectric layer, a semiconductor layer comprised of a polymer semiconductor compound of formula 1,

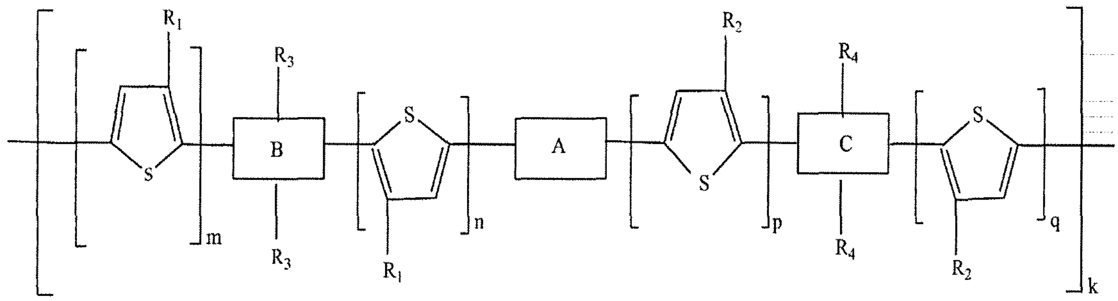

(1)

wherein $R_1$, $R_2$, $R_3$ and $R_4$ are side chains independently selected from the group consisting of a hydrogen atom, a hydrocarbon group, a heteroatom, and combinations thereof, and wherein at least one of the $R_1$, $R_2$, $R_3$ and $R_4$ side chains are not a hydrogen atom,
wherein k represents the number of repeating units of from 1 to about 200; A is a divalent linkage; and B and C are independently selected from the group consisting of a bond, a divalent linkage, and combinations thereof,
wherein m, n, p and q each individually represent from 0 to about 20,
wherein if the both B and C are thieno[3,2-*b*]thiophene, m and n cannot be 1 and p and q cannot be 1, and
wherein $R_1$, $R_2$, $R_3$ and $R_4$ are arranged in a manner promoting high mobility and providing a weak side chain interaction,
the method comprising:

forming the gate electrode and gate dielectric layer ,
depositing the semiconductor compound of formula 1 on the substrate to form an active layer of the semiconductor compound on the surface of the substrate,
wherein no high-temperature annealing is conducted following the formation of the active layer of the semiconductor compound; and
depositing the source electrode and the drain electrode.

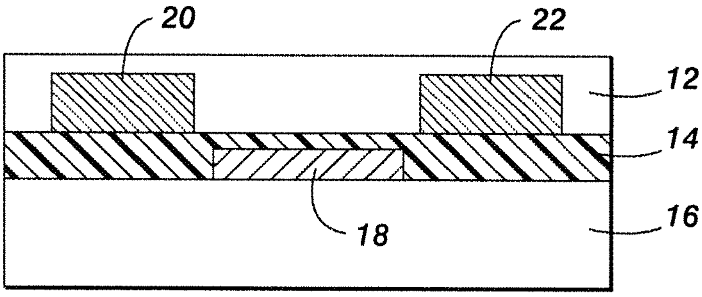


FIG. 1

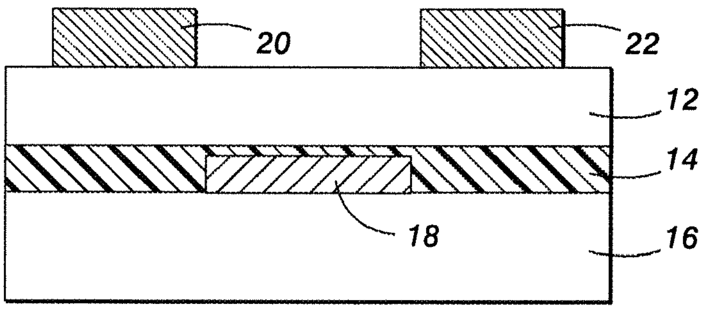


FIG. 2

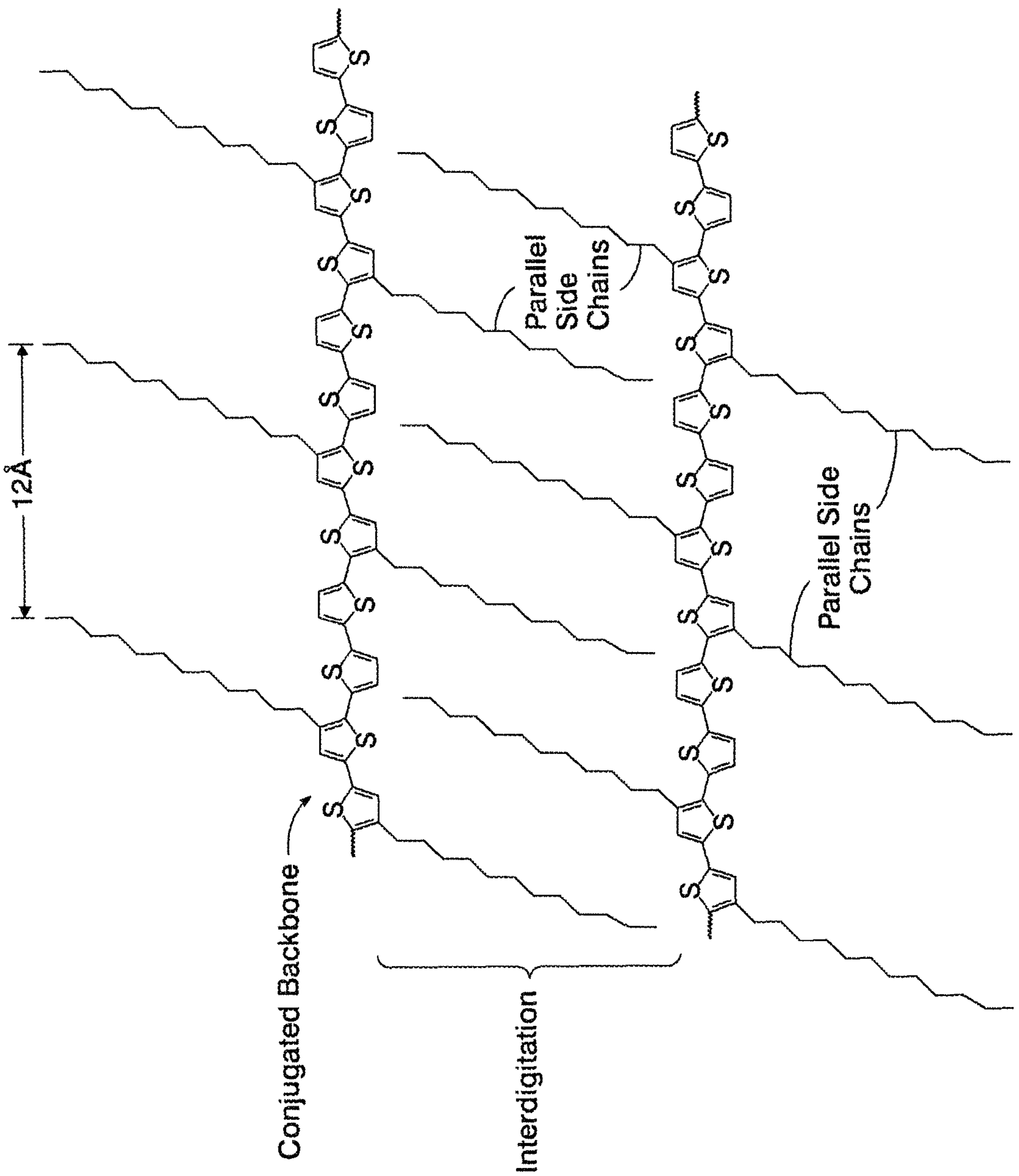
12Å
Conjugated Backbone
Interdigitation
Parallel Side Chains
Parallel Side Chains

FIG. 3

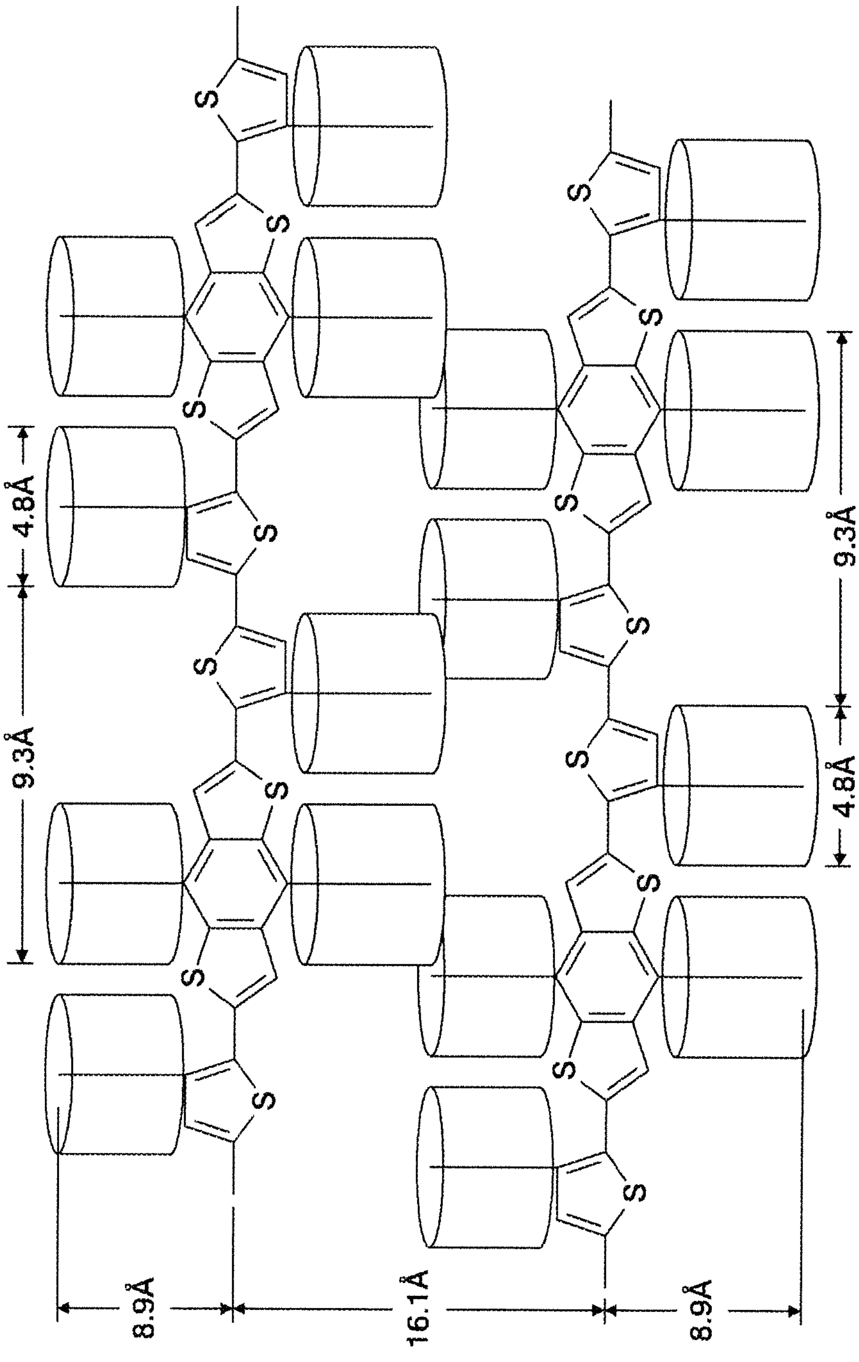


FIG. 4

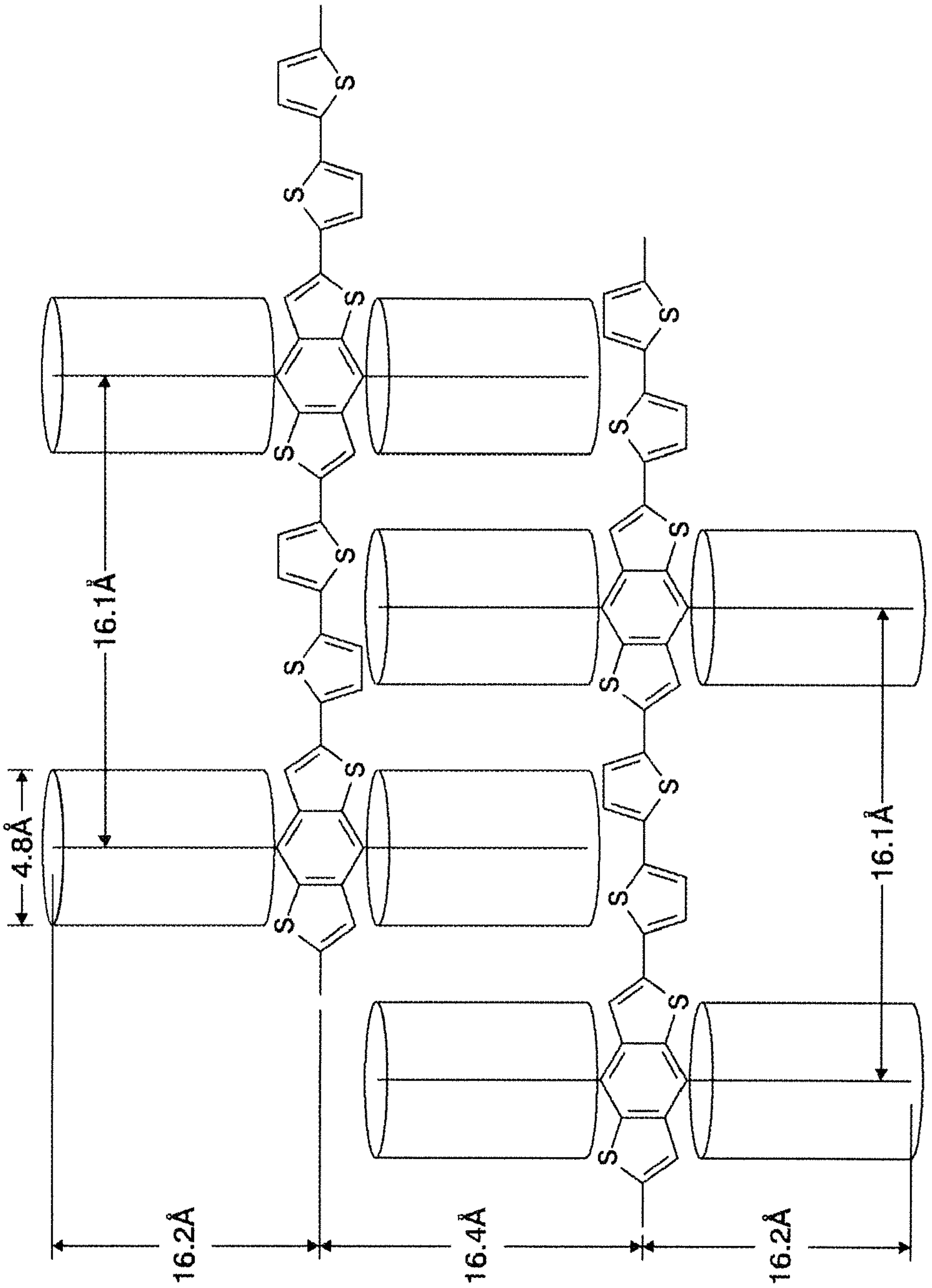


FIG. 5

Europäisches Patentamt
European Patent Office
Office européen des brevets

# PARTIAL EUROPEAN SEARCH REPORT

under Rule 62a and/or 63 of the European Patent Convention. This report shall be considered, for the purposes of subsequent proceedings, as the European search report

Application Number
EP 09 15 0157

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | BENG S ONG ET AL: "Thiophene Polymer Semiconductors for Organic Thin-Film Transistors" CHEMISTRY - A EUROPEAN JOURNAL, WILEY - V C H VERLAG GMBH & CO. KGAA, WEINHEIM, DE, vol. 14, 25 March 2008 (2008-03-25), pages 4766-4778, XP007908781 ISSN: 0947-6539 * the whole document * ----- | 1-15 | INV. C08G61/02 C08G61/12 H01L51/00 H01L51/05 |
| X | THI TUYET MAI DANG ET AL.: "Synthesis and Characterization of Poly(Benzodithiophene) Derivative for Organic Thin Film Transistors" JOURNAL OF POLYMER SCIENCE: PART A: POLYMER CHEMISTRY, vol. 45, no. 22, 4 October 2007 (2007-10-04), pages 5277-5284, XP002532392 * abstract * scheme 1 * figure 4 * * table 1 * ----- -/-- | 1-14 | |

TECHNICAL FIELDS SEARCHED (IPC)

C08G
C08L
C09D
H01L

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 15 June 2010 | Meiners, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04E07)

Europäisches Patentamt
European Patent Office
Office européen des brevets

# PARTIAL EUROPEAN SEARCH REPORT

Application Number
EP 09 15 0157

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 1 916 250 A (XEROX CORP [US]) 30 April 2008 (2008-04-30) * claims 1-8; examples I,II * ----- | 1-15 | |
| | | | TECHNICAL FIELDS SEARCHED (IPC) |

EPO FORM 1503 03.82 (P04C10)

Europäisches Patentamt
European Patent Office
Office européen des brevets

**INCOMPLETE SEARCH SHEET C**

Application Number
EP 09 15 0157

Claim(s) searched incompletely:
1-15

Reason for the limitation of the search:

The initial phase of the search revealed a very large number of documents relevant to the issue of novelty. So many documents were retrieved that it is impossible to determine which parts of the claims 1-15 may be said to define subject-matter for which protection might legitimately be sought (Article 84 EPC). In independent claims 1 and 15, the groups B and C can be optional. Likewise, the thiophene groups in the formula (I) are optional elements, thus giving rise to an extremely large number of embodiments covered by claims 1 and 15. The desideratum "wherein R1,R2,R3, and R4 are arranged in a manner promoting high mobility and providing a weak side chain interaction" of claims 1 and 15 includes the relative and vague features "high mobility" and "weak side chain interaction", which do neither restrict the scope of the search to a reasonable number of hits. For these reasons, a meaningful search of the whole claimed subject matter of claims 1-15 could not be carried out (Rule 63 EPC).

In addition, the present claims 1 and 15 relate to an extremely large number of possible compounds/methods. Support and disclosure in the sense of Article 84 and 83 EPC is to be found however for only a very small proportion of the compounds/methods claimed, see the examples provided in the present application and figure 4. The non-compliance with the substantive provisions is to such an extent, that a meaningful search of the whole claimed subject-matter of the claim could not be carried out (Rule 63 EPC and Guidelines B-VIII, 3). The extent of the search was consequently limited.
Moreover, in the light of claim 9 the units B and C in claim 1 encompass embodiments, which in contrast to formula (1) cannot bear two substituents R3 or R4 on opposite sides of the polymer chain (e.g. when B or C is ethinyl, furane, or thiophene, see claim 9), and the side chains R3 and R4 are missing on units B and C according to claim 10, thus providing contradictory embodiments to the wording to claim 1 and rendering the scope of claim 1 unclear (Art. 84 EPC).

The search of claims 1-15 was therefore restricted to those claimed compounds/methods which appear to be supported and a generalisation of their structural formulae, i.e. thiophene-based polymers, which comprise a divalent linkage A in the structural repeating unit, as shown in figure 4, and the examples on pages 21-24 of the description: The search was restricted to the embodiments of claims 1-15, which comprise the polymers according to formulae 3-6 of claim 10 with the proviso that n is greater than zero for formulae (3),(4), and (6) and that at least one of n and p in formula (5) is greater than zero.

## ANNEX TO THE EUROPEAN SEARCH REPORT ON EUROPEAN PATENT APPLICATION NO. EP 09 15 0157

This annex lists the patent family members relating to the patent documents cited in the above-mentioned European search report.
The members are as contained in the European Patent Office EDP file on
The European Patent Office is in no way liable for these particulars which are merely given for the purpose of information.

15-06-2010

| Patent document cited in search report | Publication date | Patent family member(s) | Publication date |
|---|---|---|---|
| EP 1916250 A | 30-04-2008 | BR PI0703903 A | 10-06-2008 |
| | | CA 2606985 A1 | 25-04-2008 |
| | | JP 2008109135 A | 08-05-2008 |
| | | KR 20080037580 A | 30-04-2008 |

EPO FORM P0459

For more details about this annex : see Official Journal of the European Patent Office, No. 12/82